# EUROPÄISCHE PATENTSCHRIFT

(11) **EP 2 041 331 B1**
(45) Veröffentlichungstag und Bekanntmachung des Hinweises auf die Patenterteilung: **22.10.2014**
(21) Anmeldenummer: 07787450.1
(22) Anmeldetag: 12.07.2007
(51) Int. Cl.: C23C 14/32, H01J 37/32, H01J 37/34, C23C 14/08

(54) **VERFAHREN ZUM ABSCHEIDEN ELEKTRISCH ISOLIERENDER SCHICHTEN**
METHOD FOR DEPOSITING ELECTRICALLY INSULATING LAYERS
PROCÉDÉ POUR LE DÉPÔT DE COUCHES ÉLECTRIQUEMENT ISOLANTES

(30) Priorität: 19.07.2006 CH 11662006
(43) Veröffentlichungstag der Anmeldung: 01.04.2009
(60) Teilanmeldung: 13156872.7
(73) Patentinhaber: Oerlikon Trading AG, Trübbach, 9477 Trübbach (CH)
(72) Erfinder: RAMM, Jürgen, 7304 Maienfeld (CH); WIDRIG, Beno, 7310 Bad Ragaz (CH); WOHLRAB, Christian, 6800 Feldkirch (AT)
(74) Vertreter: Troesch, Jacques J.
(86) Internationale Anmeldenummer: PCT/EP2007/057179
(87) Internationale Veröffentlichungsnummer: WO 2008/009619

(56) Entgegenhaltungen:
- EP-A- 0 729 173
- EP-A1- 0 658 634
- EP-A2- 1 081 248
- US-A- 3 625 848
- US-A1- 2003 209 424
- AMARATUNGA G A J ET AL: "AMORPHOUS DIAMOND-SI SEMICONDUCTOR HETEROJUNCTIONS" APPLIED PHYSICS LETTERS, AIP, AMERICAN INSTITUTE OF PHYSICS, MELVILLE, NY, US, Bd. 59, Nr. 1, 1. Juli 1991 (1991-07-01), Seiten 69-71, XP000234400 ISSN: 0003-6951

## Beschreibung

### Technisches Gebiet

Verfahren zur Herstellung isolierender Schichten mittels einer oder mehrerer Arcquellen wobei an der Targetoberfläche kein oder nur ein kleines Magnetfeld zur Unterstützung des Verdampfungsprozesses erzeugt wird. Im Besonderen bezieht sich das Verfahren auf die Herstellung von Oxiden und ein Betreiben der mindestens einen Arcquelle in sauerstoffhaltiger Atmosphäre.

### Definitionen:

- Wir verstehen im Rahmen der vorliegenden Anmeldung, bestehend aus Beschreibung, Figuren und Ansprüchen, unter einem "kleinen" Magnetfeld ein Magnetfeld, das zwischen 3 und 50 Gauss beträgt (beide Grenzen eingeschlossen), dabei bevorzugt zwischen 5 und 25 Gauss (beide Grenzen eingeschlossen).
- Wir verstehen in vorliegender Anmeldung, bestehend aus Beschreibung, Figuren und Ansprüchen unter einem Material, das "schlecht" leitet oder "schlechter" leitet, ein Material, dessen elektrische Leitfähigkeit geringer ist als die elektrische Leitfähigkeit von Metallen bzw. Metalllegierungen.
- Wir verstehen im Rahmen der vorliegenden Anmeldung, bestehend aus Beschreibung, Figuren und Ansprüchen, unter einem Magnetfeld, das "im wesentlichen" zur Targetoberfläche senkrecht ist, ein Magnetfeld, welches eine Komponente parallel zur Targetoberfläche hat - radiale Komponente - die kleiner ist als die Komponente senkrecht zur Targetoberfläche: Der resultierende Feldvektor schliesst mit einer Flächennormalen auf die Targetoberfläche einen Winkel ein, dessen Betrag kleiner als 45° ist. Die radiale Feldkomponente kann dabei auch null sein, dann fallen der Feldvektor und die Flächennormale zusammen.
- Wir verstehen im Rahmen der vorliegenden Anmeldung, bestehend aus Beschreibung, Figuren und Ansprüchen, unter einer im wesentlichen axial gepolten Spule eine Spule, deren Achse mit der Flächennormalen der Targetoberfläche in deren Zentrum einen Winkel einschliesst, dessen Betrag kleiner als 45° ist.
- Wir verstehen unter einem aus einer Spule bestehenden Magnetsystem, das eine dem Targetumfang "ähnliche" Geometrie hat, ein Magnetsystem, das, in Aufsicht auf die Targetoberfläche, innerhalb und/oder ausserhalb der Targetfläche und entlang ihres Umfangbereiches verläuft, in Seitenansicht mindestens teilweise unterhalb und/oder mindestens teilweise oberhalb und/oder mindestens teilweise auf gleicher Höhe angeordnet ist, wie der Rand des Targets.

### Stand der Technik

Mit Arcverfahren nach dem bisherigen Stand der Technik lassen sich Funkenquellen in sauerstoffhaltiger Atmosphäre, insbesondere in reinem Sauerstoff nur sehr schlecht oder gar nicht in einer für die industrielle Praxis brauchbaren Weise betreiben. Beispielsweise hat sich bei der Verwendung von bekannten Arcquellen, deren Magnetfelder darauf ausgelegt sind, den Funken auf im wesentlichen kreisförmigen Bahnen zu lenken, gezeigt, dass die Oberflächen der Targets sich mit dicken Oxidschichten belegen und der Beschichtungsprozess instabil wird. Die Targetoberfläche, auf der der Funken läuft schnürt sich ein, d.h. der Funken läuft auf einer immer kleiner werdenden Fläche des Targets, und die nicht benutzte Targetoberfläche wird stark aufoxidiert. Das führt zunächst zu starker Spritzerbildung und schliesslich zu Instabilitäten und einem Verlöschen des Funkens.

Eine Prozessführung, bei denen Arctargets mit Inertgas gespült und das Reaktivgas in der Nähe der Substratoberfläche eingelassen wird kann auf Grund des grossen anlagentechnischen Aufwands nicht in jedem Fall angewandt werden und führt nicht immer zum Erfolg, da bei einer zu hohen Inertgaskonzentration beispielsweise eine Mischung aus Metall und der eigentlich erwünschten Metallverbindung abgeschieden wird.

Eine andere Möglichkeit dieses Problem zu lösen, ist es den Funkenstrom zu pulsen, entweder durch gleichzeitiges Anlegen einer DC- und einer Pulsstromversorgung, wie in CH 00518/05 und CH 1289/2005 beschrieben, oder durch Anlegen einer einzelnen gepulsten Stromversorgung. Auf diese Weise lassen sich mehrere Arcquellen auch dann kontinuierlich und stabil betreiben, wenn sie in Sauerstoffatmosphäre laufen und sich während des Prozesses ihre Oberflächen mit einer isolierenden Schicht belegen. Dafür ist aber, zur DC-Versorgung eine zusätzlich Pulsstromversorgung oder ein spezieller, entsprechend teurer Einzelgenerator notwendig, der einem Grundstrom ein geeignetes Pulsstrommuster überlagern kann.

Bei der Abscheidung von leitenden Schichten, wie z.B. TiN, AlTiN, AlCrN u.a., ist es schon länger bekannt, dass bei zunehmendem parallel zur Oberfläche verlaufenden Magnetfeld die Dropletdichte abnimmt, während bei senkrechten zur Targetoberfläche orientierten Feldlinien tendenziell grössere Makropartikel emittiert werden. Beispiele für Arcquellen mit im Wesentlichen oberflächenparallelen Feldlinien bzw. kleiner senkrechter Magnetfeldkomponente werden in CH 00792/06) und WO 2004/057642 offenbart.

Weiters ist es aus DE 4223592 (Hovsepian) bekannt, dass man zur Minimierung der Dropletzahl und Optimierung der Targetausbeute ein äusseres Magnetfeld auf den jeweiligen Wert des durch den Lichtbogenstrom in bzw. auf der Targetoberfläche erzeugten Eigenmagnetfeldes einstellen kann, welches einen Wert von 10 Gauss (= 10⁻³ Tesla) nicht übersteigt. Das kann beispielsweise durch eine zwischen Target und Stromquelle geschaltete Spule erreicht werden. Dabei wird die Leistung des Verdampfers zusätzlich durch die Induktivität der Magnetspule stabilisiert und gleichzeitig die Plasmabildung erhöht.

Ein gänzlich unterschiedlicher Ansatz wird in US 6,334,405 mit einer Feldlinienführung, welche im Wesentlichen senkrecht zur Targetoberfläche ist, vorgeschlagen. Dabei ist die felderzeugende Spule oder der Magnetring auf gleicher Höhe oder vor der Targetoberfläche angeordnet. Gleichzeitig werden gegenüber den oben erwähnten Verfahren deutlich stärkere Magnetfelder verwendet.

Aus dem bisherigen Stand der Technik ist es nicht bekannt Magnetfelder im Hinblick auf eine Funkenverdampfung für die Herstellung isolierender bzw. oxidischer Schichten zu optimieren, bei der auch auf der Oberfläche des Targets zumindest vorübergehend isolierende oder zumindest schlechter leitende Schichtbereiche gebildet werden. Arcverfahren zur Abscheidung solcher Schichten werden bis heute auf Grund der beschriebenen Schwierigkeiten industriell nicht eingesetzt und sind auch aus dem Stand der Technik nur in Einzelfällen erwähnt.

Eine Ausnahme bildet das Patent EP0285745B1, in dem eine Dropletreduktion bei der Funkenverdampfung beschrieben wird, die auf der gegenseitigen Beschichtung beispielsweise zweier gegenüberliegender Funkentargets beruht. Dahinter steht die Beobachtung, dass nach Abpumpen der Vakuumbeschichtungsanlage und unmittelbar nach dem Zünden des Funkens in der ersten Zeit der Funken stärker aufgespaltet ist und weniger Droplets generiert. Die Schrift beschreibt ein Verfahren zur Beschichtung von Werkstücken mit unterschiedlichen metallhaltigen Verbindungen, wie TiN, ZrN und ZrO₂ wobei das Arctarget der Wiederbeschichtung durch eine geeignet positionierte zweite Verdampferquelle in einem Verhältnis von 12 bis 25 % der eigenen Verdampfungsrate ausgesetzt ist. Die Spulen zum Erzeugen der Magnetfelder über den Funkentargets sind dabei ausserhalb des Vakuums angeordnete Helmholtzspulen, die schon bei magnetischen Feldstärken von ca. 10 Gauss eine Erhöhung der gegenseitigen Beschichtungsrate erlauben. Ein solches Verfahren ist jedoch aus mehreren Gründen problematisch. Einerseits muss eine bestimmte Targetanordnung eingehalten und dabei die Gleichmässigkeit der Beschichtung sichergestellt werden, andereseits kommt es durch das gegenseitige Beschichten immer zu einem Verlust an Beschichtungsrate auf den Werkstücken und daraus folgend zu einer verringerten Wirtschaftlichkeit des Verfahrens.

US2003/0209424 A1 offenbart ein Verfahren zur Herstellung von z.B. Oxidschichten auf einem Werkstück mittels Vakuumbeschichtung. Eine elektrische Gleichstrombogenentladung wird zwischen Anode und Kathode einer Arcquelle in reaktivgashaltiger Atmosphäre betrieben. An der Oberfläche des Targets wird ein, im Wesentlichen zur Targetoberfläche senkrechtes, Magnetfeld (54) erzeugt. Zwischen der Kathode und der Anode ist ein von beiden elektrisch isolierter Begrenzungsring (19) aus Metal angeordnet.

### Darstellung der Erfindung

Aufgabe der vorliegenden Erfindung ist es, ein Verfahren gemäß Anspruch 1 zur Abscheidung isolierender Schichten mittels Funkenverdampfung zur Verfügung zu stellen, das die Nachteile des Standes der Technik vermeidet und es ermöglicht einen solchen Funkenverdampfungsprozess mit guter Produktivität zu führen. Eine weitere Aufgabe ist es, ein Verfahren zur Verfügung zu stellen durch das es erstmals ermöglicht wird auch ohne die Anwendung von gepulsten Arcquellen und/oder gleichzeitiger Spülung der Arcquellen mit Inertgas bzw. gleichzeitige Wiederbeschichtung der verdampften Targetoberfläche einen Funkenverdampfungsprozess langzeitstabil in einer reaktivgashaltigen Atmosphäre zu betreiben, bei der schlecht leitende oder isolierende Schichten abgeschieden werden.

Überraschenderweise hat es sich gezeigt, dass mit einer verhältnismässig einfachen Massnahme, wie dem Anlegen eines kleinen, im Wesentlichen an der Targetoberfläche zu dieser senkrechten, äusseren Magnetfeldes, dass mittels zumindest einer axial gepolten Spule mit einer dem Targetumfang ähnlichen Geometrie und einer senkrechten Komponente B_{z} sowie einer im Wesentlichen, d.h. über den Grossteil der Targetoberfläche kleineren radialen oder oberflächenparallelen Komponente Bᵣ, auch für die Herstellung schlecht leitender, insbesondere isolierender Schichten ein langzeitstabiler Beschichtungsprozess möglich ist. Vorzugsweise wird dabei die senkrechte Komponente B_{z} an der Targetoberfläche in einem Bereich zwischen 3 und 50 Gauss, insbesondere jedoch in einem Bereich zwischen 5 und 25 Gauss eingestellt.

Auch erübrigt sich bei einem solchen Verfahren die im Stand der Technik beschriebene Notwendigkeit der gegenseitigen Beschichtung, sodass der Wiederbeschichtungsgrad der Targetoberfläche durch andere Beschichtungsquellen kleiner 10%, bevorzugt kleiner 5%, insbesondere bevorzugt kleiner 1% oder Null % als der von der Kathode abgeführten Metallmenge gewählt werden kann.

Alternativ kann das Verfahren auch völlig ohne Magnetfeld betrieben werden, dabei muss allerdings auf die vorteilhafte erhöhte Ionisierung die auch schon bei Anlegen kleiner Magnetfeldern über der Targetobefläche auftritt, verzichtet werden.

Damit kann die Anordnung der Funkenquelle(n) im wesentlichen frei, beispielsweise parallel, gegeneinander gewinkelt oder auch gegenüberliegend gewählt, und beispielsweise die zu beschichtenden Werkstücke zwischen mehreren Funkenquellen beliebig positioniert oder bewegt werden, womit das Targetmaterial besser genutzt und die Beschichtungsrate erhöht wird. Dabei kann auch auf weitere bisher übliche Hilfsmassnahmen, wie das Spülen der Targets mit Inertgas oder die Zumischung grösserer Inertgasanteile zum Reaktivgas verzichtet werden. Insbesondere kann der Prozess auch mit einem Inertgasanteil von weniger als 30 % bevorzugt weniger als 10 % bzw. ohne I-nertgaszugabe betrieben werden. Auch eine Kombination der vorliegenden Erfindung mit der aus CH 00518/05 (reactive pulsed arc) und CH 1289/2005 (dual pulsed arc) bekannten Prozessunterstützung durch Anlegen eines Pulssignals an die Arckathode(n) ist in diesem Fall nicht notwendig, wenngleich eine solche Kombination für bestimmte Anwendungen Vorteile mit sich bringen kann, beispielsweise wenn eine erhöhte Ionisierung, eine bessere Targetausnutzung, eine höhere Beschichtungsrate oder eine schnellere Bewegung des Funkens auf der Targetoberfläche, gewünscht wird.

Das Magnetfeld über bzw. an der Targetoberfläche ist dabei so einzustellen, dass es nicht gross genug wird, um den Funken auf geometrisch bestimmten Bahnen zu halten. Dies wird durch. Einstellung der senkrechten Komponente B_{z} des Magnetfelds auf Werte kleiner 50 Gauss, bevorzugt jedoch kleiner 25 Gauss erreicht. Die Komponente Bᵣ ist entsprechend kleiner einzustellen.

Werden schlecht leitende oder isolierende Schichten mit solchen Prozessen abgeschieden, können die von DC-Verfahren mit magnetfeldunterstützuer Arcquelle bekannten Schwierigkeiten, wie eine großflächige Vergiftung der Targetoberfläche und daraus folgender Abfall der Beschichtungsrate, eine Eingrenzung der aktiven Targetoberfläche bzw. Prozessinstabilitäten, die bis zum Ausfall der Arcquelle führen können, vermieden werden. Gleichzeitig kann mit diesem Verfahren eine bessere Qualität der Oberfläche des Beschichtungsguts erzielt werden, da sich der Funken schon bei vergleichsweise kleinen Funkenströmen in mehrere kleine Brennpunkte aufteilt, die sich rasch über die Targetoberfläche bewegen und somit einen gleichmässigen Targetabtrag bei einer geringen Emission von Droplets ermöglichen. Somit scheint die Vergiftung der Targetoberfläche, im Vergleich zu leitenden Oberflächen, zusätzlich noch zur besseren Verteilung des Funkens beizutragen.

Besonders deutlich ist dieser Effekt bei isolierenden Schichten, die die Elektronenemission der metallischen Targetoberfläche heraufsetzen. Beispiele dafür sind Aluminiumoxidschichten oder Aluminiummetalloxidschichten die durch das Verdampfen von Legierung des Aluminiums beispielsweise mit einem oder mehreren der Übergangsmetalle der IV. bis VI. Nebengruppe sowie Fe, Si, B und C, bevorzugt von einer AlTi-, AlTa-, AlV-, AlCr-, bzw. einer AlZr-Legierung in sauerstoffhaltiger Atmosphäre hergestellt werden können. Dabei wird bevorzugt gar kein oder nur ein verhältnismässig geringer Anteil von Inertgas, bzw. Stickstoff, vorzugsweise kleiner 20 vol%, insbesondere kleiner 10 vol% verwendet um eine vollständige Oxidation der von den Targets verdampften Metallteilchen zu gewährleisten. Eine ähnliche gute Verteilung des Funkens auf der Targetoberfläche kann bei der Herstellung von isolierenden boridischen Schichten, wie beispielsweise TiB₂ beobachtet werden. Auch hier kann der Prozess in boranhaltiger Athmosphäre, beispielsweise mit Diboran, auch ohne oder mit nur geringer Zumischung von Inertgas, bzw. Stickstoff, gefahren werden.

Als Erklärung für das vorliegende Verhalten bietet sich hier, ohne Anspruch auf Vollständigkeit und wissenschaftliche Beweisführung, die unterschiedliche Elektronenemission oder Elektronenaustrittsarbeit von metallischen zu isolierenden, bzw. oxidischen Oberflächen an. So zeigt beispielsweise Aluminiumoxid eine wesentlich höhere Elektronenemission als metallisches Aluminium. Vermutlich kommt es daher bei dem erfindungsgemässen Verfahren zu einem durch die Elektronenemission der vergifteten Oberfläche kontrolliertem Funkenverlauf. Da der Funken nicht mehr durch die Querbeschleunigung eines radialen Magnetfelds auf eine Bahn gezwungen wird, springt er bevorzugt auf die Stellen des Targets mit der höchsten Elektronenemission. Im Falle eines Aluminiumtargets, das unter Sauerstoff funkenverdampft wird, läuft er an die Stelle wo die Aluminiumoxidschicht am schnellsten wächst. Ein schwaches senkrechtes Magnetfeld kann dabei die Emission zusätzlich unterstützen, wohingegen ein zu starkes senkrechtes Magnetfeld negative Auswirkungen hat. Letzteres könnte darin begründet sein, dass Magnetfelder nicht mit technisch und wirtschaftlich vertretbarem Ausmass völlig homogen über einer Targetoberfläche erzeugt werden können. Damit kommt bei stärkeren senkrechten Magnetfeldern auch immer eine wachsende parallele Komponente dazu, die schliesslich die freie Beweglichkeit des Funkens auf der Oberfläche einschränkt. Zum Halten des Funkens auf der Targetvorderseite können bekannte Massnahmen, wie Confinementringe aus isolierendem Material (bspw. Bornitrid) bzw. gut leitende Confinementringe, die den Funken durch ein durch den bewegten Funken selbst im Ring erzeugtes Wirbelstromfeld zurückstossen, angewandt werden.

Um technische Schichtsystem mit speziellen funktionellen Eigenschaften herzustellen ist es, je nach Anwendungszweck wünschenswert, gemeinsam mit den erwähnten isolierenden Schichten noch weitere, beispielweise metallische, nitridische, carbidische oder carbonitridische Haft- und/oder Hartschichten auf dem Werkstück aufzubringen, wobei bevorzugt als letzter Beschichtungsschritt eine oxydhaltige Schicht bzw. eine Oxidschicht aufgebracht wird. Letztere können beispielsweise als Einlaufschicht bzw. als Oxidationsschutz für die darunterliegenden Hartschichten eingesetzt werden. Für das Abscheiden der weiteren Schichtsysteme können an sich bekannte Verfahren, vorteilhaft jedoch PVD-Verfahren wie Sputtern, Niedervoltbogenbeschichten, insbesondere aber wieder Funkenverdampfen vorgesehen werden. Auch die Herstellung von Mehrfachschichtsystemen, wobei abwechselnd leitende und nichtleitende oder unterschiedliche nichtleitende Schichten abgeschieden werden, ist mit einem erfindungsgemässen Verfahren möglich. Dazu kann beispielsweise eine Arcquelle abwechselnd unter Stickstoff und Sauerstoff betrieben, oder mehrere Arcquellen mit unterschiedlichem Targetmaterial versehen und anschliessend das eine Material als Nitrid, Carbonitrid oder andere Verbindung, das andere Material als nichtleitendes Oxid abgeschieden werden. Dazu können zwischen den Schichten im Gegensatz zu anderen PVD- und CVD-Verfahren auch problemlos Übergansschichten zwischen nichtleitenden und leitenden Schichtbereichen mit beispielsweise ansteigendem bzw. abfallendem Sauerstoffgehalt erzeugt werden, was ein grosser Vorteil des erfindungsgemässen Verfahrens ist. Im Vergleich dazu treten bei Sputterprozessen instabile Parameterbereiche durch die Oberflächenvergiftung von Targets auf (Hysteresekurve), wodurch es zu schlagartigen Änderung der Abscheidebedingungen kommt. Auch das umständliche Einstellen unterschiedlicher Temperaturniveaus zur Abscheidung verschiedener Hartstoffe und Inertgasspülungen zwischen den einzelnen Prozessschritten, wie bei CVD-Verfahren notwendig, entfällt. Ganz allgemein kann dieses Verfahren bei viel niedrigeren Temperaturen als CVD-Verfahren betrieben werden und ist daher beispielsweise auch zur Beschichtung von Stählen geeignet.

Bei der Abscheidung von Multilayern kann sich das Problem ergeben, unterschiedliche Targetmaterialien zu verdampfen wobei sich manche Materialien nur unter Anlegen eines Magnetfelds mit einer brauchbaren Targetausnutzung verdampfen lassen. In diesen Fällen kann es von Vorteil sein dem DC-Quellenstrom zusätzlich ein Pulssignal zu überlagern. Bezüglich weiterer Details einer solchen Prozessführung sei auf die zwei vorangehenden, bereits oben erwähnten Anmeldungen CH 00518/05 und CH 1289/2005 verwiesen in denen zwei Möglichkeiten eines solchen Pulsbetriebs im Detail offenbart werden. Weiters können, wie sich auch aus oben Erwähntem ergibt, an das Magnetsystem zum Arcverdampfen eines metallisch blanken Targetmaterials andere Anforderungen gestellt werden als an ein Magnetsystem zum Verdampfen desselben Materials mit einer Oxidbelegung. Beispielsweise ist es zum Arcverdampfen von TiAl zur Abscheidung von TiAlN von Vorteil die Quelle mit einem Magnetsystemen zu betreiben. Je nach Ti/Al-Verhältnis können dabei unterschiedliche Magnetsysteme zu optimalen Ergebnissen führen, wobei eventuell Magnetfelder in der Grössenordnung der oben angegebenen Grenzen der Magnetfeldstärke oder auch darüber angewandt werden. Kann in solchen Fällen, beispielsweise bei Verwendung von Permanentmagneten, die Magnetfeldstärke nicht an die unterschiedlichen Verdampfungsbedingungen (z.B. metallische-, nitridische-, oxidische Targetoberfläche) angepasst werden, so ist bei oxidischer Targetoberfläche und entsprechend grossen Magnetfeldern ein zusätzliches Pulsen vorteilhaft oder sogar notwendig.

Ähnliches gilt für die Realisierung von gradierten Schichten und Mischschichten aus Oxiden und beispielsweise Nitriden und/oder Carbiden. In diesen Fällen arbeitet man nicht nur in reiner Sauerstoffatmosphäre, sondern in Gasgemischen mit unterschiedlichem, oft kleinem Sauerstoffanteil. Unter diesen Bedingungen wird die Elektronenemission an der Targetoberfläche nicht vollständig durch den Sauerstoff gesteuert, da nur eine teilweise oxidbelegte Targetoberfläche vorhanden ist. Auch hier kann es von Vorteil sein, ein zusätzliches Pulsen des Targetstromes vorzusehen.

Wenn auch im Allgemeinen mit dem erfidnungsgemässen Verfahren ohne weitere Massnahmen isolierende Schichten abgeschieden werden können, kann es unter Umständen, wie oben erwähnt, dennoch von Vorteil sein die Arcquelle gleichzeitig mit einem Gleichstrom als auch mit einem Puls- bzw. Wechselstrom zu speisen. Dabei wird der DC-Anteil des Stromflusses vorteilhaft im Bereich von 100 bis 300%, insbesondere zwischen 100 und 200% des Haltestroms eingestellt. Unter Haltestrom wird dabei der kleinste Strom verstanden, bei dem noch ein stabiles Betreiben einer elektrisch leitenden Arcquelle mit einer einfachen DC-Stromversorgung möglich ist. Der Wert des Haltestroms bzw. der Halteleistung hängt dabei vom Targetmaterial, von der Bauart der Arcquelle bzw. vom Betrieb der Entladung ab, beispielsweise ob diese unter Vakuum mit oder ohne Zugabe von Inert- bzw. Reaktivgas betrieben wird. Dies entspricht bei üblichen Targetmaterialien bei Verwendung der unten näher beschriebenen Arcquellen einem DC-Stromfluss im Bereich zwischen 30 bis 90 A, bevorzugt zwischen 30 und 60 A.

In einer speziellen Ausführung kann die Pulsstromversorgung zwischen einer Kathode und einer von der Arcquelle getrennt angeordneten zweiten Elektrode, insbesondere einer Kathode einer weiteren Arcquelle betrieben werden. Alternativ kann die Pulsstromversorgung auch zwischen der Arcquelle und einem anderen Quellentyp, beispielsweise einer Sputterkathode einer Sputterquelle, insbesondere eines Magnetrons geschaltet werden.

Zur Erzeugung des Magnetfelds kann beispielsweise ein an und für sich bekanntes axial gepoltes Magnetsystem, das aus zumindest eine Spule mit einer dem Targetumfang ähnlichen Geometrie besteht, mit einem Erregerstrom beaufschlagt werden. Das Magnetsystem wird dabei im Wesentlichen in einer Ebene mit der Targetoberfläche, oder bevorzugt hinter der Targetoberfläche angeordnet, da in diesem Fall eine Anordnung der Spule an Atmosphäre relativ einfach möglich ist. Die Geometrie des Magnetsystems kann dabei, aus Gründen der Platzökonomie auch etwas kleiner als der Targetumfang gewählt werden. Ist allerdings eine besonders gleichmässige vertikale Verteilung erwünscht ist eine gleiche oder sogar etwas grössere Geometrie, die beispielsweise auch ein Umfassen des Targets ermöglicht, parallel und möglichst nahe der geometrischen Ebene der Targetoberfäche günstig. Die Verwendung von quellenfernen Helmholtzanordnungen, die ein Magnetfeld über grosse Bereiche der Anlage erzeugen, ist nicht notwendig und aus Gründen der Flexibilität auch nicht erstrebenswert.

In besonders einfacher Weise kann ein solches Magnetfeld erzeugt werden, indem der Gleichstrom und/oder der Puls- bzw. Wechselstrom der Stromquelle über eine Spule, beispielsweise eine Spule nach obiger Bauart, an die Kathode geleitet werden. In diesem Fall kommt man ohne einen Generator für die Magnetspule aus. Besonders wirkt sich die Nutzung einer solchen Hintereinanerschaltung von Spule und Kathode im Pulsbetrieb aus, wo es zu einer zusätzlichen Ionisierung kommt, die den Pulsbetrieb unterstützt und die Elektronenemission verstärkt. Die Windungszahl der Spule für die oben angegebenen Quellenströme wird dazu vorteilhaft zwischen 1 und 20, bevorzugt zwischen 1 und 10, insbesondere zwischen 1 und 5 Windungen gewählt. Damit ist es auch möglich, das Magnetfeld im Wesentlichen auf die Grösse des jeweiligen Wertes des Eigenmagnetfeldes des Lichtbogenstroms einzustellen, der sich meist in einer Grössenordnung kleiner oder gleich 10 Gauss bewegt. Ein kurzfristig höheres äusseres Magnetfeld, das beispielswiese beim Durchlaufen einer Pulsspitze, bzw. einer steilen Pulsflanke durch die Spule entsteht, stört üblicherweise nicht.

Alternativ ist es natürlich auch möglich das Magnetfeld separat von einer DC oder gepulst betriebenen Arcquelle mit einer eigenen Pulsversorgung und Ansteuerung zu speisen. Wird die Arcquelle ebenfalls gepulst kann eine Synchronisation vorgesehen werden.

Auf diese Art lassen sich bei entsprechender Auslegung der Spulen und bei Bedarf zusätzlichem Vorsehen eines Magnetrings auch grössere Magnetfelder erzeugen, wenn eine höhere Plasmadichte erwünscht ist. In diesem Fall ist es aber bei der Abscheidung von isolierenden Schichten vorteilhaft, zusätzlich zu dem an den Arcquellen anliegenden DC-Signal ein Pulssignal wie oben erwähnt anzulegen.

Weiters ist es vorteilhaft, das Verfahren mit einer Arcquelle zu betreiben, bei der zwischen der Kathode und der Anode ein von beiden elektrisch isolierter Begrenzungsring angeordnet ist und dieser entweder aus einem elektrischen Isolator, wie beispielsweise BN, oder einem sehr gut leitenden Metall, wie beispielsweise Al, Cu, Ag besteht. Dadurch wird insbesondere in Kombination mit einem kleinen Magnetfeld sichergestellt, dass der Funken die Oberfläche des Targets nicht verlässt.

### Kurze Beschreibung der Zeichnungen

Im Folgenden wird die Erfindung anhand von Figuren, welche lediglich verschiedene Ausführungsbeispiele darstellen, näher erläutert. Es zeigen
- Fig.1: Oberflächen von reaktiv gearcten Targets
- Fig.2: Arcquelle mit Magnetsystem
- Fig.3: Feldstärke Z bei bekanntem Verfahren
- Fig.4: Feldstärke V bei bekanntem Verfahren
- Fig.5: Arcquelle mit Spule
- Fig.6: Feldstärke bei erfindungsgemässem Verfahren

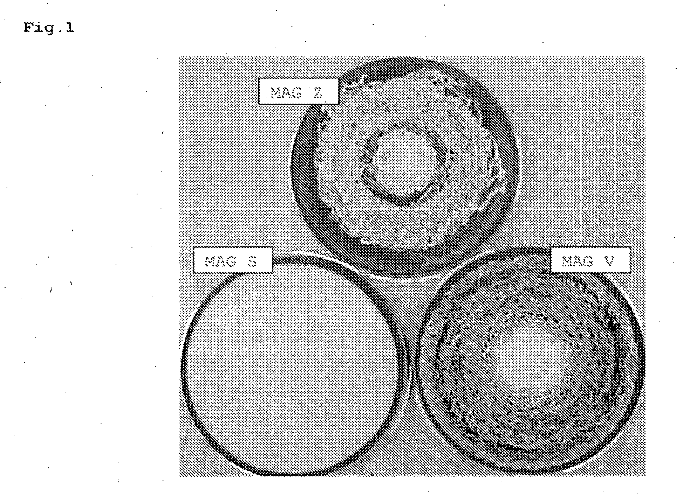

Aus Fig.1 ist der Zustand der Oberfläche verschiedener Funkentargets nach Betreiben in reiner Sauerstoffatmosphäre erkennbar. Für den Versuch wurden Targets mit einem Durchmesser von 160 mm und einer Dicke von 6 mm auf eine Standardarcquelle der Firma Balzers in einer RCS Beschichtungsanlage montiert und unter Verwendung verschiedener Magnetsysteme für 50 Minuten, bei einem Quellenstrom von 180A in reiner Sauerstoffatmosphäre betrieben. Die verwendeten Parameter waren wie folgt:

| | |
|---|---|
| Quellenstrom_{arc}: | 180A |
| O₂-Fluss: | stufenweise von 400 sccm auf 1600 sccm erhöht, es wurde in reiner Sauerstoffatmosphäre gefahren. |
| Stufenhöhe / -breite: | 300 sccm / 10 Min |
| Prozessdruck: | 0.44 bis 4.9 Pa |
| Substratspannung: | biopolar asymmetrischer Puls: -100 V / 36µs, +100 V / 4µs |
| T_{substrat} : | 550°C |

In Fig.1 bezeichnen "MAG.Z" und "MAG V" zwei Targets, die mit einem relativ starken Magnetfeld mit einer ausgeprägten radialen Komponente Bᵣ betrieben wurden. Die Oberfläche zeigt in beiden Fällen einen sehr unregelmässigen Abtrag und deutliche im Wesentlichen ringförmige Spuren des Funkenverlaufs. Der Funken hat dabei verhältnismässig tiefe Spuren und in beiden Fällen schon optisch erkennbar ein Abtragsmaximum im Zentrum des Targets hinterlassen. Die Oberfläche ist in beiden Fällen so rauh und beschädigt, dass die Targets für einen weiteren Einsatz ohne Nachbearbeitung der Oberfläche nicht mehr zu gebrauchen sind. Die Funkenbahn selbst schnürt sich während des Betriebs immer weiter ein und es kommt zu Prozessinstabilitäten. Ein solches Verhalten liess sich bis jetzt nur, wie in CH 00518/05 und CH 1289/2005 beschrieben, durch Pulsen des Targetstroms weitgehend vermeiden. Dies bedeutet aber einen zusätzlichen Aufwand und erfordert spezielle Stromversorgungen.

Ein völlig anderes Bild zeigt die Oberfläche in Fig.1 "MAG S", die mit Ausnahme des Magnetfelds unter sonst gleichen Parametern betrieben wurde, wie die Oberflächen der Targets MAG Z und MAG V in Fig.1. Die Oberfläche erscheint gleichmässig über den gesamten Bereich abgetragen, was auch durch Profilometermessungen bestätigt werden konnte. Voraussetzung für ein solches Verhalten ist ein kleines Magnetfeld mit zumindest einer kleinen radialen Komponente. Die vertikale Komponente kann etwas freier gewählt werden. Im Folgenden wird auf die wesentlichen Unterschiede der verwendeten Magnetsysteme kurz eingegangen.

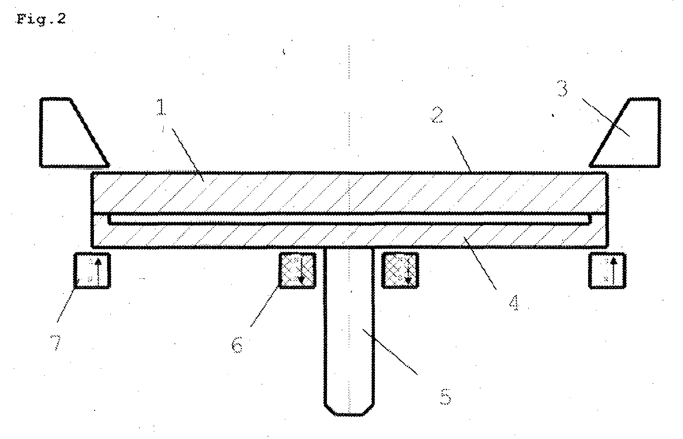

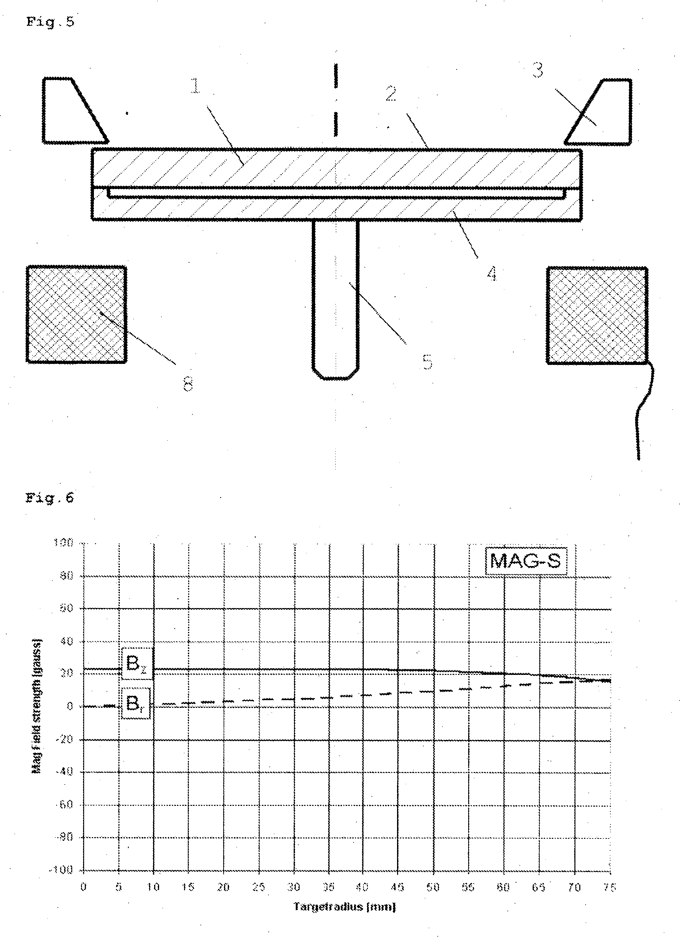

Fig.2 zeigt einen schematischen Querschnitt durch eine Arcquelle mit einem Magnetsystem, wie es für die Targets aus Fig.1 MAG Z und MAG V verwendet wurde. Um die Oberfläche 2 eines auf einer Kühlplatte 4 montierten Targets 1 ist ein umlaufender Konfinementring 3 zur Begrenzung des Funkens auf der Targetoberfläche angeordnet. Eine üblicherweise ebenfalls umlaufende Gegenelektrode, meist eine Anode wird hier nicht näher dargestellt. Im zentralen rückwärtigen Bereich des Targets befindet sich die Stromzuführung 5, die auch eine hier nicht näher dargestellte Kühlwasserzu- und Ableitungen umfassen kann. Ebenfalls im zentralen rückwärtigen Bereich befindet sich ein innerer Permanentmagnetring 6, im Bereich des äusseren Targetumfangs ist ein äusserer Permanentmagnetring 7 angeordnet. Beide Magnetringe sind axial gegenpolig magnetisiert, so dass ein Teil der Feldlinien, die von der Oberseite des äusseren Permanentmagnetring 7 austreten in der Oberseite des inneren Permanentmagnetring 6 wieder eintreten, während der Feldlinienverlauf auf der Rückseite im Bezug auf die Ringebene im wesentlichen spiegelbildlich verläuft. Zur Änderung der Feldstärke können beispielsweise unterschiedlich starke Magnete, zusätzlich eine Spule wie in Fig.5 oder auch andere Anordnungen verwendet werden.

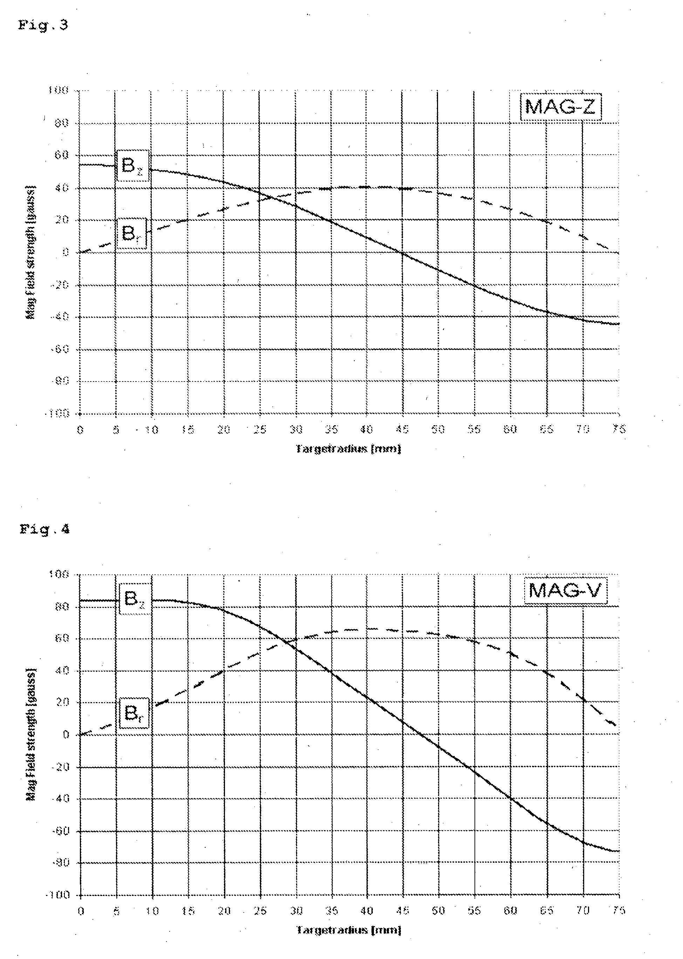

In Fig.3 wird die lokale Feldstärke eines Magnetsystems dargestellt, wie sie sich bei Verwendung eines so gebauten serienmässigen Magnetsystem "MAG Z" der Firma Balzers an der Oberfläche eines Arctargets einstellt. Die Figur zeigt den Feldstärkenverlauf der vertikalen Komponente B_{z} und der radialen Br Komponente auf einer Targethälfte. B_{z} weisst in der Mitte (O-Koordinate) und am Rand (75 mm) ein Maximum auf und durchläuft bei ca. 45 mm die Nullinie. Der durch den Schnittpunkt der absoluten Komponenten definierte 45° Punkt, d.h. der Punkt bzw. Umkreis auf dem die Feldlinien in einem Winkel von 45° auf der Targetoberfläche eintreffen, liegt bei ca. 27 und 59 mm. Im Zwischenbereich ist die radiale Komponente Br grösser als B_{z} und durchläuft ein Maximum. Im Gegensatz zu B_{z} durchläuft Bᵣ auf der jeweiligen Targethälfte keinen Richtungswechsel und schneidet die Nullinie jeweils im Nullpunkt und am Targetrand. Wie zu erwarten ist der Zwischenbereich, in dem auf den, bzw. die über das Target laufenden Funken relativ hohe radiale Beschleunigungskräfte wirken, ein bevorzugter Aufenthaltsbereich, was an der entsprechenden Erosionscharakteristik in Fig.1 "MAG Z" auch klar zu erkennen ist. Andererseits kommt es auch durch die im zentralen Targetbereich sehr kleine radiale Komponente und der damit verbundenen langsamen Bewegung einzelner Funken, die den bevorzugten Aufenthaltsbereich verlassen, durch Überhitzung und in der Folge explosionsartiges Verdampfen zu einem erhöhten Abtrag, einer Beschädigung der Oberfläche und erhöhter Dropletbildung. Dieser Effekt fällt am Targetrand weniger ins Gewicht, da einerseits im Verhältnis zum zentralen Bereich weniger Funken pro Fläche aus dem bevorzugten Bereich übertreten und andererseits der Funken durch ein in dem metallisch, beispielsweise aus Kupfer ausgeführten Begrenzungsring selbstinduziertes Wirbelstromfeld zurückgestossen wird.

Fig.4 zeigt die entsprechende Feldstärkencharakteristik des, für das Verdampfen des in Fig.1 gezeigten Targets mit Magnetsystem "MAG V". Bei prinzipiell ähnlicher Charakteristik, unterscheidet sich das Magnetfeld duch eine gegenüber Fig.3 im Durchschnitt etwa 50% höhere Feldstärke für beide Komponenten. Dementsprechend sieht man auf der Targetoberfläche in Fig.1 "MAG V" auch im Aussenbereich einen verstärkten Abtrag. Auch in diesem Fall ist die Oberfläche schwer beschädigt.

Schliesslich zeigt Fig.5 einen schematischen Querschnitt durch eine Arcquelle mit einem Magnetsystem "MAG S" 8, wie es für das Verdampfen der Oberflächen des Targets in Fig.1 "MAG S" gemäss dem erfindungsgemässen Verfahren verwendet wurde. Anstatt der Permanentmagnetringe 6, 7 aus Fig.2 wird hier eine hinter dem Target 1 im Bereich der Projektion des Targetumfangs angebrachte elektromagnetische Spule 8 verwendet.

Vorteilhaft sind hier Magnetsysteme, die aus einer oder mehreren elektrischen Spulen, ohne oder nur mit geringer Unterstützung durch starke Permanentmagnete, aufgebaut sind. Bei diesen Systemen kann der Spulenstrom analog zur Änderung des Oberflächenzustands des Targets geändert werden. Beispielsweise kann bei der Herstellung eines kontinuierlichen Übergangs zwischen einer leitenden nitridischen Hartschicht zu einer nichtleitenden, oxidischen Schicht das Magnetfeld parallel zur Stickstofframpe heruntergeregelt werden, während der Sauerstofffluss kontinuierlich erhöht wird. Auf diese Art können auch ohne einen Pulsbetrieb der Arcquelle beliebige kontinuierliche Übergänge mit Materialien hergestellt werden, die für das Verdampfen der leitenden Oberfläche eine Magnetfeldunterstützung benötigen.

In Fig.6 ist die Feldstärke dargestellt, die sich beim Betrieb eines solchen Magnetsystems mit geringen Strömen ergibt. In diesem Fall wurde ein serienmässiges Magnetsystem "MAG S" (432 Windungen) der Firma Balzers mit einem Strom von 1A betrieben. Damit ist es möglich, wie dargestellt Magnetfelder mit einem sehr gleichmässigen Verlauf der B_{z}-Komponente als auch im Durchschnitt sehr kleinen Bᵣ-Komponente einzustellen. Vorteilhaft wird die B_{z}-Komponente kleiner 50 Gauss, insbesondere kleiner oder gleich 30 Gauss eingestellt. Wenn auch überraschenderweise die Arcquellen in Sauerstoffatmosphäre prinzipiell ohne Magnetfeldunterstützung mit akzeptabler Rate und einem Erosiomsmuster ähnlich dem von Fig.1 "MAG S" betrieben werden können, bringt doch die Verwendung eines wie eben beschriebenen Magnetsystems noch eine etwas bessere Verteilung. Auch bei Feldern mit einem B_{z} kleiner 10 Gauss, beispielsweise bei 3 und 5 Gauss konnte bereits eine Wirkung festgestellt werden. Von Vorteil ist dabei ein möglichst gleichmässiger B_{z}-Verlauf, der über einen Grossteil der Targetoberfläche um nicht mehr als 10 bis maximal 20% schwankt. Lediglich im Targetrandbereich, ca. 10 bis 20 mm von der Targetkante ist eine etwas grössere Abweichung zulässig. Zusätzlich erleichtert ein solches Magnetsystem jene Beschichtungsverfahren, bei denen das Target nacheinander zum Erzeugen von leitenden und schlecht bzw. nicht leitenden Schichten verwendet wird, da hier die Felder an den jeweiligen Verfahrensschritt angepasst werden können. Selbstverständlich können zur Optimierung solcher Verfahren auch andere, dem Fachmann bekannte Magnetsysteme verwendet werden. Beispielsweise wäre für manche Prozesse der Einsatz eines zusätzlichen senkrecht zur Targetebene verschiebbaren Systems vorteilhaft, um eine, beispielsweise wie für die Herstellung von bestimmten Metallnitriden günstige Magnetfeldverteilung mit grösseren Magnetfeldern an der Targetoberseite etwa analog Fig.3 und 4 herzustellen.

Im folgenden Beispiel wird ein vollständiger Ablauf eines Beschichtungsverfahren mit einem schwachen im Wesentlichen senkrechten Magnetfeld im Bereich der Targetoberfläche gegeben.

Nach Einlegen der Werkstücke in dafür vorgesehenen zwei- oder dreifach rotierbare Halterungen und Einbringen der Halterungen in die Vakuumbehandlungsanlage, wird die Behandlungskammer auf einen Druck von ca. 10⁻⁴ mbar abgepumpt.

Zur Einstellung der Prozesstemperatur wird ein durch Strahlungsheizungen unterstütztes Niedervoltbogen(NVB)plasma zwischen einer durch eine Blende abgetrennte Kathodenkammer mit Heisskathode und den anodisch geschalteten Werkstücken in einer Argon-Wasserstoffatmosphäre gezündet.

Dabei werden folgende Heizparameter eingestellt:

| | |
|---|---|
| Entladestrom NVB | 250 A |
| Argonfluss | 50 sccm |
| Wasserstofffluss | 300 sccm |
| Prozessdruck | 1.4x10⁻² mbar |
| Substrattemperatur | ca. 550°C |
| Prozesszeit | 45 min |

Alternativen dazu sind dem Fachmann bekannt. Die Substrate wurden dabei bevorzugt als Anode für den Niedervoltbogen geschaltet und bevorzugt zusätzlich unipolar oder bipolar gepulst.

Als nächster Prozessschritt wird das Aetzen gestartet. Dafür wird der Niedervoltbogen zwischen dem Filament und der Hilfsanode betrieben. Auch hier kann eine DC, eine gepulste DC oder eine mit Wechselstrom betriebene MF oder RF Versorgung zwischen Werkstücken und Masse geschaltet werden. Bevorzugt wurden die Werkstücke aber mit einer negativen Biasspannung beaufschlagt.

Dabei wurden folgende Ätzparameter eingestellt:

| | |
|---|---|
| Argonfluss | 60 sccm |
| Prozessdruck | 2.4x10⁻³ mbar |
| Entladestrom NVB | 150 A |
| Substrattemperatur | ca. 500°C |
| Prozesszeit | 45 Min |
| Bias | 200 - 250 V |

Um die Stabilität der Niedervoltbogenentladung (NVB) bei der Herstellung isolierender Schichten zu gewährleisten, wird bei allen NVB-unterstützten Prozesschritten entweder mit einer heissen, leitfähigen Hilfsanode gearbeitet oder eine gepulste Hochstromversorgung zwischen Hilfsanode und Masse geschaltet.

Im nächsten Prozessschritt erfolgt die Beschichtung des Substrates mit einer AlCrO-Schicht und einer TiAlN-Zwischenschicht. Alle Beschichtungsprozesse können bei Bedarf an erhöhter Ionisation noch durch das Plasma des Niedervoltbogens unterstütz werden.

Dabei wurden folgende Parameter bei Abscheidung der TiAlN-Zwischenschicht eingestellt:

| | |
|---|---|
| Argonfluss | 0 sccm (ohne Argonzugabe) |
| Stickstofffluss | Druckgeregelt auf 3 Pa |
| Prozessdruck | 3x10⁻² |
| DC Quellenstrom TiAl | 200 A |
| Strom des Quellen-Magnetfeldes (MAG S) | 1 A |
| DC Substratbias | U = -40 V |
| Substrattemperatur | ca. 550° C |
| Prozesszeit | 25 Min |

Für den ca. 15 min langen Übergang zur eigentlichen Funktionsschicht werden die AlCr-Arcquellen mit einem DC-Quellenstrom von 200 A zugeschaltet, wobei der positiven Pol der DC-Quelle mit dem Anodenring der Quelle und Masse verbunden ist. An die Substrate wird ein DC Substratbias von -40 V während dieses Schrittes anlegt. 5 Minuten nach dem Einschalten der AlCr-Targets wird mit dem Sauerstoffeinlass begonnen, wobei dieser innert 10 Min von 50 auf 1000 sccm geregelt wird. Gleichzeitig wird N₂ auf ca. 100 sccm zurückgeregelt. Kurz vor Einlass des Sauerstoffs wird der Substratbias von DC auf bipolares Pulsen umgeschaltet und auf U = -60 V erhöht. Am Ende der Sauerstofframpe werden die beiden TiAl-Targets ausgeschaltet. Damit sind die Zwischenschicht und der gradierte Uebergang zur Funktionsschicht fertiggestellt.

Die Beschichtung der Substrate mit der eigentlichen Funktionsschicht erfolgt im reinen Sauerstoff. Da es sich bei Aluminiumoxid um isolierende Schichten handelt, wird entweder eine gepulste oder eine AC Biasversorgung verwendet.

Die wesentlichen Funktionsschichtparameter wurden dabei wie folgt eingestellt:

| | |
|---|---|
| Sauerstofffluss | 1000 sccm |
| Prozessdruck | 2x10⁻² mbar |
| DC Quellenstrom Al | 200 A |
| Strom des Quellen-Magnetfeldes (MAG S) | 0.5 A |
| Substratbias | U = 60 V (bipolar, 36 µs negativ, 4 µs positiv) |
| Substrattemperatur | ca. 550° C |
| Prozesszeit | 60 bis 120 min |

Mit oben beschriebenem Prozess konnten .gut haftende und harte Schichten erzeugt werden. Vergleichtests der Schicht auf Dreh- und Frässwerkzeugen ergaben eine gegenüber bekannten TiAlN-Schichten deutlich verbesserte Standzeit obwohl die Rauhigkeit deutlich über den Rauhwerten optimierter reiner TiAlN-Schichten lag.

## Patentansprüche

1. Verfahren zur Herstellung isolierender Schichten auf zumindest einem Werkstück mittels Vakuumbeschichtung, wobei eine elektrische Bogenentladung zwischen mindestens einer Anode und einer Kathode einer Arcquelle in reaktivgashaltiger Atmosphäre betrieben wird, und an der Oberfläche eines mit der Kathode elektrisch verbundenen Targets ein äusseres Magnetfeld, umfassend eine zur Targetoberfläche senkrechte Komponente B_{z} sowie eine diesbezüglich kleinere radiale oder oberflächenparallele Komponente Bᵣ, zur Unterstützung des Verdampfungsprozesses erzeugt wird, indem ein, aus zumindest einer axial gepolten Spule bestehendes Magnetsystem mit einem Erregerstrom beaufschlagt wird, **dadurch gekennzeichnet, dass** das Magnetsystem eine dem Targetumfang ähnliche Geometrie und Grösse aufweist, und dass an der Targetoberfläche die senkrechte Komponente B_{z} in einem Bereich zwischen 3 und 50 Gauss gewählt wird.

2. Verfahren nach Anspruch 1, **dadurch gekennzeichnet, dass** die senkrechte Komponente B_{z} an der Targetoberfläche in einem Bereich zwischen 5 und 25 Gauss eingestellt wird.

3. Verfahren nach Anspruch 1, **dadurch gekennzeichnet, dass** das Magnetsystem in einer Ebene mit der Targetoberfläche oder bevorzugt hinter der Targetoberfläche angeordnet ist.

4. Verfahren nach einem der vorhergehenden Ansprüche, **dadurch gekennzeichnet, dass** die Funkenentladung, bzw. die zumindest eine Arcquelle gleichzeitig mit einem Gleichstrom als auch mit einem Puls- bzw. Wechselstrom gespeist wird.

5. Verfahren nach Anspruch 4, **dadurch gekennzeichnet, dass** durch eine Isolierbelegung der Targetoberfläche eine Erhöhung des DC-Anteils der Quellenspannung von zumindest 10%, bevorzugt zumindest 20% gegenüber dem Betrieb mit einer Oberfläche ohne Isolierbelegung bewirkt wird.

6. Verfahren nach Anspruch 4, **dadurch gekennzeichnet, dass** zwischen der Kathode einer Arcquelle als erster Elektrode und einer von der Arcquelle getrennt angeordneten zweiten Elektrode eine Pulsstromversorgung betrieben wird.

7. Verfahren nach Anspruch 6, **dadurch gekennzeichnet, dass** die zweite Elektrode als Kathode einer weiteren Arcquelle betrieben wird und diese ebenfalls mit einer DC-Stromversorgung verbunden ist.

8. Verfahren nach Anspruch 6, **dadurch gekennzeichnet, dass** als zweite Elektrode eine Sputterkathode geschaltet ist.

9. Verfahren nach einem der vorhergehenden Ansprüche, **dadurch gekennzeichnet, dass** zumindest zwei Targets in gegeneinander gewinkelter oder gegenüberliegender Anordnung betrieben werden und zumindest ein Werkstück zwischen den Targets angeordnet wird.

10. Verfahren nach einem der vorhergehenden Ansprüche, **dadurch gekennzeichnet, dass** der Erregerstrom der Gleichstrom und/oder der Puls- bzw. Wechselstrom ist, der von der Stromquelle über die Spule an die Kathode geleitet wird.

11. Verfahren nach Anspruch 10, **dadurch gekennzeichnet, dass** die Spule so ausgelegt wird, dass sich das äussere Magnetfeld bei Fliessen des Erregerstroms auf den Wert des Eigenmagnetfeldes des Lichtbogenstroms einstellt.

12. Verfahren nach Anspruch 11, **dadurch gekennzeichnet, dass** eine Spule mit einer Wicklungszahl zwischen 1 bis 20, bevorzugt zwischen 1 bis 10, insbesondere zwischen 1 und 5 Windungen verwendet wird.

13. Verfahren nach einem der vorhergehenden Ansprüche, **dadurch gekennzeichnet, dass** ein Target aus einer aluminiumhaltigen Legierung verwendet und von der Targetoberfläche eine aluminiumhaltige Legierung bzw. eine Verbindung einer aluminiumhaltigen Legierung verdampft wird.

14. Verfahren nach Anspruch 13, **dadurch gekennzeichnet, dass** die Legierung reines Aluminium, bzw. eine Legierung des Aluminiums mit einem oder mehreren der Übergangsmetalle der IV. bis VI. Nebengruppe sowie Fe, Si, B und C umfasst, bevorzugt aber eine AlTi-, AlTa-, AlV-, AlCr-, bzw. eine AlZr-Legierung umfasst.

15. Verfahren nach einem der vorhergehenden Ansprüche, **dadurch gekennzeichnet, dass** die reaktivgashaltige Atmosphäre Sauerstoff umfasst, bzw. aus Sauerstoff besteht, und eine oxidhaltigen Schicht, bevorzugt ein Oxid abgeschieden wird.

16. Verfahren nach Anspruch 15, **dadurch gekennzeichnet, dass** zusätzlich zu zumindest einer oxidhaltigen Schicht zumindest eine andere Haft- und/oder Hartschicht auf dem Werkstück aufgebracht wird, wobei bevorzugt als letzter Beschichtungsschritt eine oxidhaltige Schicht, bevorzugt ein Oxid aufgebracht wird.

17. Verfahren nach Anspruch 16, **dadurch gekennzeichnet, dass** zumindest einmal zwischen zwei unmittelbar aufeinander folgenden Haft-, Hart- und/oder Oxidschichten eine Übergangsschicht aufgebracht wird, die Elemente der zwei unmittelbar aufeinander folgenden Schichten enthält.

18. Verfahren nach einem der Ansprüche 1 bis 15, **dadurch gekennzeichnet, dass** die reaktivgashaltige Atmosphäre eine borhaltige Verbindung umfasst, bzw. aus einer borhaltigen Verbindung besteht, und eine borhaltige Schicht, bevorzugt ein Borid, insbesondere bevorzugt TiB₂ abgeschieden wird.

19. Verfahren nach Anspruch 1, **dadurch gekennzeichnet, dass** die Arcquelle entweder in einer Vakuumbeschichtungsanlage alleine betrieben wird, oder andere Beschichtungsquellen so in der Vakuumbeschichtungsanlage angeordnet sind, dass der Wiederbeschichtungsgrad der Targetoberfläche kleiner 10%, bevorzugt kleiner 5%, insbesondere bevorzugt kleiner 1% als die von der Kathode verdampfte Metallmenge ist.

20. Verfahren nach Anspruch 1, **dadurch gekennzeichnet, dass** zwischen der Kathode und der Anode ein von beiden elektrisch isolierter Begrenzungsring angeordnet wird, der entweder aus einem elektrischen Isolator, vorzugsweise BN, oder Metall, vorzugsweise aus Al, Cu, Ag besteht.

## Claims

1. Method for producing insulating layers on at least one workpiece by vacuum coating, wherein an electrical arc discharge is operated between at least one anode and one cathode of an arc source in an atmosphere containing reactive gas, and wherein an external magnetic field is generated at the surface of a target electrically connected to the cathode, comprising a component B_{z} perpendicular to the target surface as well as a relatively smaller component Bᵣ radial or parallel to the target surface, in order to assist the evaporation process, by supplying an excitation current to a magnet system comprising at least one axially polarized coil, **characterised in that** the magnet system has a geometry similar in size to the target, and wherein the perpendicular component B_{z} at the target surface is selected in a range between 3 and 50 Gauss.

2. Method according to claim 1, **characterised in that** the perpendicular component B_{z} at the target surface is set in a range between 5 and 25 Gauss.

3. Method according to claim 1, **characterised in that** the magnet system is arranged in one plane with the target surface or preferably behind the target surface.

4. Method according to one of the preceding claims, **characterised in that** the spark discharge respectively the at least one arc source is powered simultaneously with a direct current as well as with a pulse or alternating current.

5. Method according to claim 4, **characterised in that** an insulation coating of the target surface can effect an increase of the DC proportion of the source current by at least 10%, preferably at least 20%, compared to the operation with a surface without insulation coating.

6. Method according to claim 4, **characterised in that** a pulse current supply is operated between a cathode of an arc source as first electrode and a second electrode disposed separately from the arc source.

7. Method according to claim 6, **characterised in that** the second electrode can be operated as a cathode of a further arc source and the latter is likewise connected with a DC power supply.

8. Method according to claim 6, **characterised in that** a sputter cathode is connected as second electrode.

9. Method according to one of the preceding claims, **characterised in that** at least two targets are operated in an arrangement at an angle or opposite to one another and at least one workpiece is positioned between the targets.

10. Method according to one of the preceding claims, **characterised in that** the excitation current is the direct current, and/or the pulse or alternating current that is lead from the current source over the coil to the cathode.

11. Method according to claim 10, **characterised in that** the coil is designed in such a manner that the external magnetic field sets itself essentially to the value of the intrinsic magnetic field of the arc current when the excitation current flows.

12. Method according to claim 11, **characterised in that** a coil with a winding number between 1 to 20, preferably between 1 and 10, in particular between 1 and 5 windings, is used.

13. Method according to one of the preceding claims, **characterised in that** a target of an alloy containing aluminium is used and **in that** an alloy containing aluminium or a compound of an alloy containing aluminium is evaporated from the target surface.

14. Method according to claim 13, **characterised in that** the aluminium alloy includes pure aluminium, or an alloy of aluminium with one or several of the transition metals of the IV^{th} to the VI^{th} subgroup as well as Fe, Si, B and C, preferably an AlTi, AlTa, AlV, AlCr or an AlZr alloy.

15. Method according to one of the preceding claims, **characterised in that** the atmosphere containing reactive gas includes oxygen or is constituted of oxygen, and a layer containing oxides, preferably an oxide, is deposited.

16. Method according to claim 15, **characterised in that** in addition to at least one layer containing oxides, at least one other undercoating and/or hard layer is laid on the workpiece, with the final coating step being preferably a layer containing oxides, preferably an oxide layer.

17. Method according to claim 16, **characterised in that** at least once between two directly successive undercoating, hard and/or oxide layers, a transition layer is laid, which contains elements of the two directly successive layers.

18. Method according to one of the claims 1 to 15, **characterised in that** the atmosphere containing reactive gas includes a compound containing boron, or consists of a compound containing boron, and a boridic layer, preferably a boride, in particular preferably TiB₂, is deposited.

19. Method according to claim 1, **characterised in that** the arc source is either operated alone in a vacuum coating installation or other coating sources are arranged in the installation in such a manner that the degree of recoating of the target surface is less than 10%, preferably less than 5%, in particular preferably less than 1% of the metal quantity vaporized by the cathode.

20. Method according to claim 1, **characterised in that** between the cathode and the anode a stop ring electrically insulated from both is placed, the latter being made either of an electrical insulator, preferably BN, or of a highly conducting metal, preferably Al, Cu, Ag.

## Revendications

1. Procédé pour fabriquer des couches isolantes sur au moins une pièce par application d'un revêtement sous vide, étant précisé qu'une décharge en arc électrique est produite entre au moins une anode et une cathode d'une source d'arc dans une atmosphère contenant un gaz réactif, et qu'à la surface d'une cible reliée électriquement à la cathode est produit un champ magnétique extérieur qui comprend une composante B_{z} perpendiculaire à la surface de cible et une composante Bᵣ plus petite, radiale ou parallèle à la surface, pour renforcer le processus d'évaporation, en sollicitant avec un courant d'excitation un système composé d'au moins une bobine à polarisation axiale, **caractérisé en ce que** le système magnétique présente une géométrie et une taille similaires à l'étendue de la cible, et **en ce qu'**au niveau de la surface de cible, la composante perpendiculaire B_{z} est choisie dans une plage située entre 3 et 50 Gauss.

2. Procédé selon la revendication 1, **caractérisé en ce que** la composante perpendiculaire B_{z} est réglée au niveau de la surface de cible dans une plage située entre 5 et 25 Gauss.

3. Procédé selon la revendication 1, **caractérisé en ce que** le système magnétique est disposé dans le même plan que la surface de cible ou de préférence derrière la surface de cible.

4. Procédé selon l'une des revendications précédentes, **caractérisé en ce que** la décharge à étincelle ou la ou les sources d'arc sont alimentées simultanément avec un courant continu et un courant pulsé ou alternatif.

5. Procédé selon la revendication 4, **caractérisé en ce qu'**un recouvrement isolant de la surface de cible entraîne un accroissement de la proportion de courant continu de la tension de source d'au moins 10%, de préférence d'au moins 20% par rapport à un fonctionnement avec une surface sans recouvrement isolant.

6. Procédé selon la revendication 4, **caractérisé en ce qu'**une alimentation en courant pulsé est utilisée entre la cathode d'une source d'arc, comme première électrode, et une seconde électrode disposée séparément de la source d'arc.

7. Procédé selon la revendication 6, **caractérisé en ce que** la seconde électrode est utilisée comme cathode d'une autre source d'arc et celle-ci est reliée elle aussi à une alimentation en courant continu.

8. Procédé selon la revendication 6, **caractérisé en ce qu'**une cathode de pulvérisation cathodique est montée comme seconde électrode.

9. Procédé selon l'une des revendications précédentes, **caractérisé en ce qu'**au moins deux cibles disposées suivant un certain angle ou face à face sont utilisées et au moins une pièce est disposée entre les cibles.

10. Procédé selon l'une des revendications précédentes, **caractérisé en ce que** le courant d'excitation est constitué par le courant continu et/ou le courant pulsé ou alternatif qui est amené de la source de courant jusqu'à la cathode par l'intermédiaire de la bobine.

11. Procédé selon la revendication 10, **caractérisé en ce que** la bobine est conçue de telle sorte que le champ magnétique extérieur, lors du passage du courant d'excitation, se règle à la valeur du champ magnétique propre du courant d'arc électrique.

12. Procédé selon la revendication 11, **caractérisé en ce qu'**une bobine avec un facteur de bobinage situé entre 1 et 20, de préférence entre 1 et 10, en particulier entre 1 et 5 spires est utilisée.

13. Procédé selon l'une des revendications précédentes, **caractérisé en ce qu'**une cible composée d'un alliage contenant de l'aluminium est utilisée, et à partir de la surface de cible est évaporé un alliage contenant de l'aluminium ou un composé d'un alliage contenant de l'aluminium.

14. Procédé selon la revendication 13, **caractérisé en ce que** l'alliage comprend de l'aluminium pur, ou un alliage de l'aluminium avec un ou plusieurs métaux de transition des sous-groupes IV à VI ainsi que Fe, Si, B et C, mais de préférence un alliage AlTi, AlTa, AlV, AlCr ou un alliage AlZr.

15. Procédé selon l'une des revendications précédentes, **caractérisé en ce que** l'atmosphère contenant un gaz réactif comprend de l'azote, ou se compose d'azote, et une couche oxydique, de préférence un oxyde, est déposée.

16. Procédé selon la revendication 15, **caractérisé en ce qu'**en plus d'au moins une couche oxydique est appliquée sur la pièce au moins une autre couche adhérente et/ou dure, étant précisé qu'une couche oxydique, de préférence un oxyde, est appliquée comme dernière étape de revêtement.

17. Procédé selon la revendication 16, **caractérisé en ce qu'**une couche de transition est appliquée au moins une fois entre deux couches d'adhérence, dures et/ou oxydiques qui se suivent directement, laquelle couche de transition contient des éléments des deux couches qui se suivent directement.

18. Procédé selon l'une des revendications 1 à 15, **caractérisé en ce que** l'atmosphère contenant un gaz réactif comprend un composé contenant du bore, ou se compose d'un composé contenant du bore, et une couche contenant du bore, de préférence un borure, en particulier TiB₂, est déposée.

19. Procédé selon la revendication 1, **caractérisé en ce que** soit la source d'arc est utilisée seule dans une installation d'application de revêtement sous vide, soit d'autres sources d'application de revêtement sont disposées dans l'installation d'application de revêtement sous vide de telle sorte que le degré de renouvellement de revêtement de la surface cible soit inférieur de 10%, de préférence inférieur de 5%, en particulier inférieur de 1% à la quantité de métal évaporée de la cathode.

20. Procédé selon la revendication 1, **caractérisé en ce qu'**il est prévu entre la cathode et l'anode une bague de délimitation, isolée électriquement de celles-ci, qui se compose soit d'un isolateur électrique, de préférence BN, soit de métal, de préférence Al, Cu, Ag.
